Europäisches Patentamt

European Patent Office

Office européen des brevets

(19)

(11) Numéro de publication: **0 256 918**
**A1**

(12) **DEMANDE DE BREVET EUROPEEN**

(21) Numéro de dépôt: **87401757.7**

(22) Date de dépôt: **28.07.87**

(51) Int. Cl.⁴: **H 03 K 19/094**
**H 03 K 19/00**

(30) Priorité: **05.08.86 FR 8611333**

(43) Date de publication de la demande:
**24.02.88 Bulletin 88/08**

(84) Etats contractants désignés: **DE GB IT**

(71) Demandeur: **THOMSON-CSF**
**173, Boulevard Haussmann**
**F-75379 Paris Cédex 08 (FR)**

(72) Inventeur: **Perea, Ernesto**
**THOMSON-CSF SCPI 19, avenue de Messine**
**F-75008 Paris (FR)**

(74) Mandataire: **Taboureau, James et al**
**THOMSON-CSF SCPI 19, avenue de Messine**
**F-75008 Paris (FR)**

(54) **Porte logique BFL compensée en température.**

(57) L'invention concerne une porte logique de type BFL, c'est-à-dire "Buffered FET Logic", réalisée en transistors "normalement passant" en matériaux du groupe III-V tel que GaAs et destinée aux opérations logiques rapides.

Une porte logique BFL comporte un étage d'entrée (1,2) et un étage de sortie dans lequel un transistor intermédiaire (3) alimenté par une source de courant (4), débite un courant ($I_D$) à travers une diode de décalage (5). Si la température varie la chute de tension ($V_D$) dans la diode de décalage (5) varie, et le signal de sortie ($V_o$) peut ne plus pincer le transistor d'entrée (1') d'une porte BFL suivante. Pour compenser en température, une diode de compensation (9) est montée dans la polarisation ($V_{GS}$) du transistor source de courant (4). Le courant ($I_D$) débité varie au sens inverse de la chute de la tension ($V_c$) dans la diode de compensation (9) et rétablit la chute de tension ($V_D$) dans la diode de décalage (5).

Application aux circuits logiques rapides.

FIG_6

EP 0 256 918 A1

**Description**

## PORTE LOGIQUE BFL COMPENSEE EN TEMPERATURE

La présente invention concerne un perfectionnement aux portes logiques réalisées au moyen de dispositifs semiconducteurs et connues sous l'abréviation de BFL pour Buffered FET Logic, ou logique tampon à transistors à effet de champ. Les portes logiques BFL sont généralement utilisées en association entre elles pour réaliser des circuits intégrés complexes, la sortie d'une porte constituant l'entrée d'une porte suivante. Mais elles sont sensibles aux variations de température qui fait varier les paramètres des transistors utilisés, ce qui fait également varier le niveau de la tension de sortie d'une porte, d'où une perturbation dans le fonctionnement des portes suivantes. Le perfectionnement apporté par l'invention consiste à compenser en température une porte BFL en ajoutant dans sa source de courant une diode qui augmente, lrosque la température augmente, la tension $V_{GS}$ entre grille et source du transistor qui sert de source de courant. La variation, en fonction de la température, des caractéristiques de la diode contrecarre la variation des caractéristiques de la source de courant.

Les portes logiques BFL sont actuellement bien connues et elles sont l'une des structures logiques les plus couramment utilisées en logique rapide, dont les temps de réponse se comptent en picosecondes, parce qu'elles utilisent des transistors normalement passants, plus connus sous le nom de "normally-on", qui sont plus faciles à réaliser que les transistors normalement bloquants, ou "normally-off" ce qui rend très tolérante la technologie de fabrication de circuits intégrés dans lesquels sont comprises des portes BFL.

Sommairement, une porte BFL comprend deux étages:
- un étage d'entrée dans lequel un transistor d'entrée reçoit un signal d'entrée, et est monté en série avec une première source de courant,
- un étage de sortie dans lequel un transistor intermédiaire reçoit un signal issu du drain du transistor d'entrée, et est monté en série avec une deuxième source de courant constituée par une diode en série avec un transistor. Le signal de sortie est prélevé entre la diode et le drain du transistor source de courant.

Le rôle de la diode est de provoquer un décalage du signal de sortie, de façon à ce que, en absence de signal d'entrée, la tension de sortie d'une porte BFL soit inférieure à la tension de seuil du transistor d'entrée de la porte BFL suivante. Donc dans un circuit associant plusieurs portes BFL en série, qu'une porte ne soit pas excitée si celle qui la précède ne l'est pas.

Mais il est connu qu'une diode a des caractéristiques qui varient avec la température. Ainsi, si la température augmente, la chute de tension dans la diode de décalage diminue, et la tension de sortie peut ainsi remonter, avec la température, au dessus de la tension de seuil du transistor d'entrée de la porte BFL suivante, ce qui fait que ce transistor n'est pas bloqué lorsqu'il devrait l'être.

Pour supprimer cet inconvénient, l'invention prévoit de compenser la variation de la tension de décalage dans la diode par une variation de sens opposé du courant qui traverse la diode. Pour obtenir ce résultat, la polarisation grille-source du transistor de la deuxième source de courant est modifiée au moyen d'une seconde diode montée entre grille et source dudit transistor. La polarisation du transistor et donc égale à la chute de tension dans la seconde diode, et elle fait varier le courant fourni par le transistor dans le même sens que la variation de température. Si la température augmente, la tension de décalage de la première diode tend à diminuer, mais la source de courant fournit un courant plus élevé qui tend à augmenter la tension de décalage dans la diode de décalage, donc cette tension de décalage reste sensiblement stable. Et inversement si la température diminue.

De façon plus précise, l'invention concerne une porte logique compensée en température, de type BFL, comportant dans son étage d'entrée, un transistor d'entrée dont la grille reçoit le signal logique d'entre ($V_I$) et un transistor alimenté par une première tension $V_{DD}$, et dans son étage de sortie, un transistor intermédiaire, alimenté par la même tension $V_{DD}$, et dont la grille reçoit le signal issu du drain du transistor d'entrée, ce transistor intermédiaire étant monté en série avec au moins une diode de décalage elle-même en série avec une source de courant constituée par un transistor alimenté par une deuxième tension $V_{SS}$, le signal logique de sortie ($V_O$) étant prélevé au point commun entre la diode de décalage et le drain du transistor source de courant, cette porte logique BFL étant caractérisée en ce que, en vue de compenser la variation avec la température de la chute de tension $V_D$ introduite par la diode de décalage, au moins une diode de compensation est introduite, dans le sens passant, entre la source et la grille du transistor source de courant de l'étage de sortie, la deuxième tension d'alimentation $V_{SS}$ étant appliquée au point commun entre la diode de compensation et la grille du transistor.

L'invention sera mieux comprise et ses avantages mieux détaillés par l'exposé qui va suivre d'un exemple de réalisation, en s'appuyant sur les figures jointes en annexe qui représentent :
- figure 1 : schéma électrique d'une porte logique BFL selon l'art connu,
- figure 2 : diagramme des signaux d'entrée et de sortie du second étage d'une porte BFL selon l'art connu,
- figure 3 : courbes $I_D = f(V_D)$ d'une diode, en fonction de la température,
- figure 4 : courbes $I_D = f(V_{DS})$ d'un transistor, en fonction de la température,
- figure 5 : courbes de compensation de la variation de tension de décalage d'une diode par la variation du courant qui la traverse, selon l'invention,
- figure 6 : schéma électrique d'une porte logique BFL compensée en température, selon l'invention,

- figure 7 : modélisation de la source de courant dans une porte BFL selon l'art connu,
- figure 8 : modélisation de la source de courant dans une porte BFL compensée en température, selon l'invention.

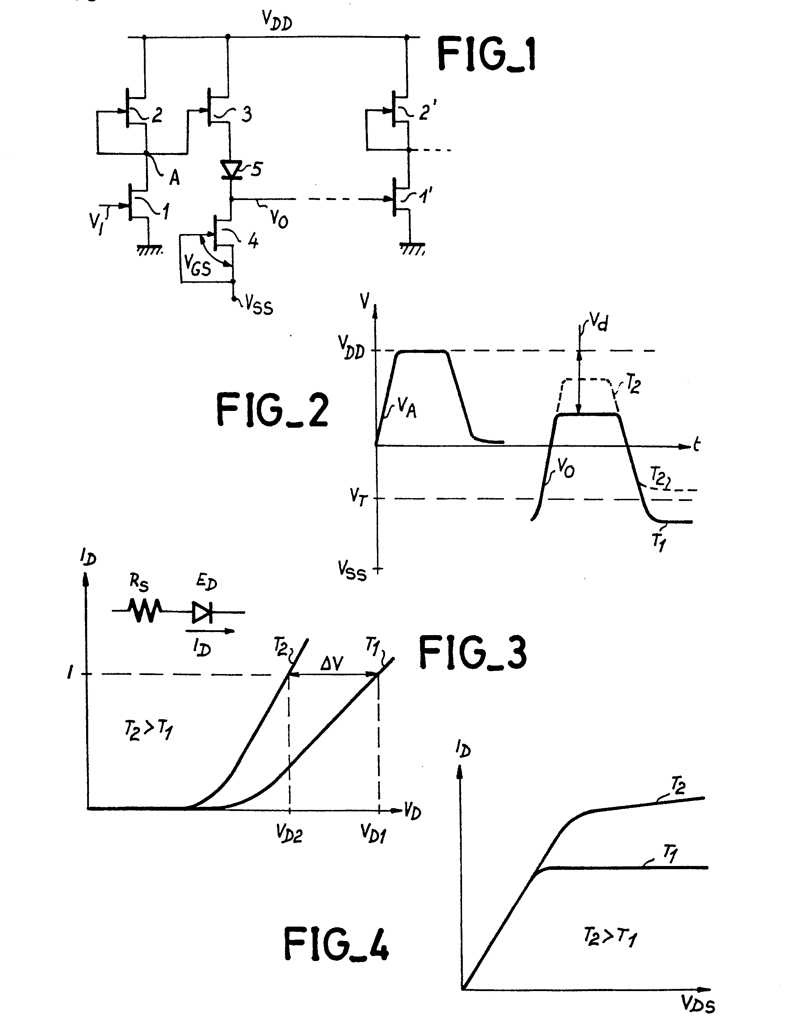

La figure 1 représente le schéma électrique d'une porte logique BFL selon l'art connu, et son exposé permettra de mieux comprendre quels sont les problèmes qui se posent lorsque la température de fonctionnement d'un telle porte varie.

En bref, une porte BFL comprend deux étages.

L'étage d'entrée est constitué par un transistor à effet de champ 1, monté source à la masse et alimenté à travers une première source de courant constituée par un transistor à effet de champ 2, dont le drain est au potentiel $V_{DD}$, et dont la grille est réunie à la source. Le transistor d'entrée 1 reçoit sur sa grille des signaux logiques d'entrée, c'est-à-dire des 0 logiques et des 1 logiques. Ce premier étage est alimenté entre $V_{DD}$ et la masse et sa sortie est prise en un point A, commun au drain du transistor 1 et à la source du transistor 2.

L'étage de sortie est constitué par un transistor intermédiaire 3 qui reçoit sur sa grille le signal issu de A et est monté en série avec une deuxième source de courant qui est un transistor 4. Ce second étage est alimenté entre $V_{DD}$ et $V_{SS}$. Entre les deux transistors 3 et 4 est intercalée une diode de décalage 5 qui entraîne un décalage de tension du signal de sortie par rapport au signal d'entrée : le signal de sortie $V_o$ est prélevé entre la cathode de la diode 5 et le drain de la source de courant 4, et il est très généralement appliqué sur la grille du transistor d'entre 1' d'une autre porte BFL qui est esquissée sur la figure 1.

Selon la valeur désirée du décalage, une porte BFL peut comporter plus d'une diode telle que 5 : on voit couramment avec deux ou trois diodes en série, mais il y en a toujours au moins une.

De façon à éviter les confusions avec d'autres tensions dont les sigles sont normalisés, on conviendra d'appeler $V_I$ et $V_o$ les tensions d'entrée et de sortie, respectivement, de la porte BLF.

La figure 2 permet de comprendre le rôle de la diode de décalage 5, et l'importance de la stabilité en température d'une porte BFL. Les tensions y sont portées en ordonnée entre $V_{SS}$ et $V_{DD}$ et le temps en abscisse.

La première courbe $V_A$ correspond au signal appliqué sur la grille du transistor intermédiaire 3 lorsqu'une impulsion logique $V_I$est appliquée à l'entrée de la porte BFL : ce signal varie depuis zéro volt jusqu'à $V_{DD}$.

La (ou les) diode de décalage 5 introduit pour le signal de sortie $V_o$ un décalage $V_d$ sur l'échelle $V_{SS}$ - $V_{DD}$, de sorte que la courbe $V_o$ soit à un niveau inférieur à la tension de seuil $V_T$ lorsque le signal d'entrée $V_I$, ou $V_A$, est à zéro. Ainsi, $V_o$ inférieur à $V_T$permet de pincer le transistor d'entrée 1' de la porte BFL suivante : si dans une série, la première porte BFL n'est pas activée, les portes suivante ne le sont pas non plus.

Ceci est valable à une température $T_1$ de fonctionnement. Mais on sait que les caractéristiques des dispositifs semiconducteurs varient avec la température : à une température $T_2$, supérieure à $T_1$,la tension de décalage $V_d$ introduite par la diode de décalage 5 est moindre, et la courbe représentative de $V_o$, en pointillés à $T_2$, peut ne plus descendre en dessous de la tension de seuil $V_T$ des transistors. Dans ce cas, le transistor d'entrée 1' d'une porte BFL dans une série de portes serait activé, alors que la première porte ne l'est pas, d'autant plus que la tension de seuil $V_T$ dérive vers $V_{SS}$tandis que $V_o$dérive vers $V_{DD}$ lorsque la température augmente.

En effet, la figure 3 montre la variation de la chute de la tension $V_D$ d'une diode, en fonction du courant $I_D$ qui la traverse, à différentes températures $T_1$ et $T_2$ ($T_2 > T_1$). Pour un courant I qui traverse la diode constant puisque fourni par une source de courant, si la température augmente de $T_1$ à $T_2$ il s'ensuit une diminution de tension $\Delta V = V_{D1} - V_{D2}$ : cette diminution de la tension de décalage peut faire passer la tension de sortie $V_o$ de la porte BFL au-dessus de la tension de seuil $V_T$, sur la figure 2.

Si on pose :
- $R_S$ = résistance série d'une diode polarisée en direct,
- $E_D$ = hauteur de barrière, ou tension de coude de cette diode,
- $I_D$ = courant fourni par la source de courant, qui traverse la diode,
la tension de décalage $V_D$ d'une diode est donnée par :
$$V_D = E_D + R_S I_D$$

Mais le courant $I_D$ est lui-même fourni par le transistor 4, et varie avec une variation de température, selon les courbes de la figure 4 : pour une tension drain-source $V_{DS}$ donnée, le courant qui traverse ce transistor et qui n'est autre que $I_D$, augmente avec la température.

Si on pose :
- L = longueur de la grille du transistor source de courant,
- Z = largeur de cette même grille,
- $V_T$ = tension de seuil du transistor,
le courant $I_D$ qui le traverse est donné par :

$$I_D = K \frac{Z}{L} V_T^2$$

K étant un facteur de proportionnalité.

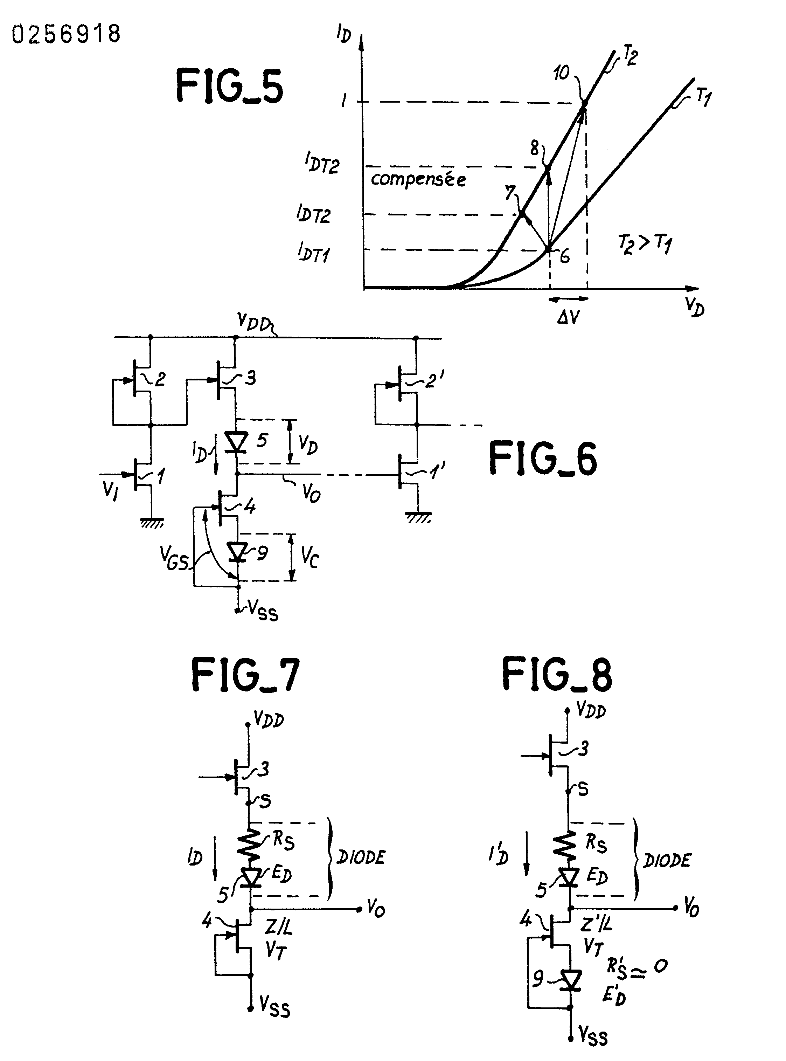

La solution apportée par l'invention à la compensation en température d'une porte BFL est exposée dans son fonctionnement en figure 5 et dans sa réalisation en figure 6.

Soit $I_D$ le courant et $V_D$ la chute de tension d'une diode de décalage 5, dont le point de fonctionnement à la température $T_1$ est en 6 par exemple et correspond à un courant $I_D T_1$. Si la diode fonctionne à une température $T_2$ ($T_2 > T_1$), sa tension de décalage $V_D$ varie, mais comme le courant $I_D$ fourni par le transistor 4 varie lui aussi de $I_D T_1$ à $I_D T_2$, le point de fonctionnement de la diode 4 est désormais en 7, qui ne correspond pas à la même tension de décalage que le point 6. Pour obtenir à la température $T_2$ la même tension de décalage qu'à la température $T_1$, il faut forcer le courant $I_D$ qui traverse la diode 4 jusqu'à amener son point de fonctionnement en 8, de même abscisse en tension que le point 6, et qui correspond à un courant $I_D T_2$ compensée.

En d'autres termes, pour compenser la variation dans un sens de la tension de décalage $V_D$ d'une diode, il faut faire varier dans un sens opposé le courant $I_D$ qui la traverse, et ceci est obtenu, dans le cas d'une porte BFL, en faisant varier la polarisation grille-source $V_{GS}$ du transistor 4 qui constitue la source de courant.

Cette variation de polarisation $V_{GS}$ est amenée par une diode de compensation montée en sens direct entre la source et la grille du transistor 4, comme représenté en figure 6.

On voit que cette figure 6 est très proche de la porte BFL classique de la figure 1, et les mêmes indices de repère désignent les mêmes objets lorsqu'ils sont communs mais on a ajouté, dans la source de courant de l'étage de sortie de la porte BFL, une diode de compensation 9, montée en polarisation directe entre la source et la grille du transistor 4. La tension $V_{SS}$ est appliquée au point commun à la cathode de la diode 9 et à la grille du transistor 4.

Soit $V_C$ la chute de tension de la diode 9, de façon à ne pas la confondre avec la tension de décalage $V_D$ de la diode 5.

Si la température de fonctionnement de la porte BFL augmente par exemple de $T_1$ à $T_2$, la tension de décalage $V_D$ de la diode 5 diminue, mais simultanément la chute de la tension $V_C$ de la diode de compensation 9 diminue. Comme la polarisation $V_{GS}$, de la grille du transistor 4 est égale à $-V_C$, cette polarisation augmente -il s'agit de transistors normalement passants, bloqués par une tension négative - et le courant $I_D$ débité par le transistor 4 augmente aussi de façon à compenser la diminution de la tension de décalage $V_D$.

Bien entendu, le fonctionnement reste comparable si on considère un abaissement de température de T2 à T1. Pour cette figure comme pour les figures précédentes, il suffit d'inverser les variations de caractéristiques si la variation de température est inversée.

Les dimensions et les paramètres, tel que la tension de seuil $V_T$ du transistor 4 sont avantageusement optimisés de façon à avoir à température ambiante les mêmes niveaux de tensions et de courant que dans une porte BFL classique, malgré la présence de la diode de compensation 9. En particulier, celle-ci peut-être calculée avec des dimensions assez grandes pour que sa résistance d'accès, ou résistance série en polarisation directe, soit quasiment nulle.

Etant donné que les portes BFL sont très généralement asso ciées en série, si la tension de décalage $V_D$ de la diode 5 d'une porte BFL varie avec la température, la tension de seuil $V_T$ du transistor d'entrée 1′ d'une porte suivante varie également avec la température. Mais il a été dit précédemment que ces deux variations sont de sens opposés (figure 2). En se reportant en figure 5, l'invention prévoit de compenser la variation de la tension de seuil $V_T$ du transistor d'entrée l'en forçant le courant $I_D$ qui traverse la diode de décalage 5 jusqu'en un point tel que 10, qui correspond à une augmentation de $V_D$, d'une valeur $\Delta V$, lorsque la température augmente. Cette augmentation de $V_D$ permet à la courbe $V_O$, en figure 2, de couper l'abscisse de $V_T$, et donc de pincer le transistor 1′ d'une porte suivante, même si la température augmente. Ce résultat peut être obtenu en montant en série plusieurs diodes de compensations 9, ce qui est nécessaire aussi si la porte BFL comporte plusieurs diodes de décalage 5 en série.

L'invention est justifiée par les équations suivantes :

Posons :

- $E_D$ = hauteur de barrière d'une diode,
- $R_S$ = résistance série d'une diode,
- $V_T$ = tension de seuil d'un transistor,
- $T$ = température, $T_A$ étant la température ambiante.

On peut définir en premier ordre :

$$E_{D(T)} = E_{D(T_A)} - \propto (T - T_A) \qquad \frac{d\, E_{D(T)}}{dT} = -\propto$$

$$R_{S(T)} = R_{S(T_A)} - \beta (T - T_A) \qquad \frac{d\, R_{S(T)}}{dT} = -\beta$$

$$V_{(T)} = V_{T(T_A)} - \gamma (T - T_A) \qquad \frac{d\, V_{T(T)}}{dT} = -\gamma$$

Considérons d'abord une porte BFL classique, dont le second étage est représenté figure 7. On peut faire l'hypothèse que le signal au poit S sur la source du transistor intermédiaire 3, n'est pas affecté par la température :

$$\frac{dV_S}{dT} = 0$$

En effet, si le transistor 3 est conducteur, le point S est pratiquement à $V_{DD}$, qui ne varie pas avec la température. $R_S$ est la résistance intrinsèque de la diode 5 : ce n'est pas une résistance ajoutée et montée avec la diode.

En reprenant l'expression de courant $I_D$ fourni par la source de courant :

$$I_D = k\, \frac{Z}{L}\, V_T^2 \qquad \text{soit} \qquad \frac{I_D}{V_T} = k\, \frac{Z}{L}\, V_T$$

et en posant que la tension $V_o$ de sortie est égale à :
$V_o = V_S - E_D - I_D R_S$
on peut dériver par rapport à la température T

$$\frac{d\, V_o}{dT} = -\frac{d\, E_D}{dT} - I_D\, \frac{d\, R_S}{dT} - R_S\, \frac{d\, I_D}{dT}$$

$$\frac{d\, I_D}{dT} = k\, \frac{Z}{L}\, 2 V_T\, \frac{d\, V_T}{d\, T} = 2\, \frac{I_D}{V_T}\, \frac{d\, V_T}{dT}$$

donc

$$\frac{d\, V_o}{d\, T} = \propto + \beta\, I_D + 2\, \gamma\, \frac{I_D R_S}{V_T}$$

pour une porte BFL classique.

Faisons maintenant le même calcul pour une porte BFL compensée en température selon l'invention, dont le second étage est représenté figure 8.

Pour la même raison que précédemment, on admettra que le signal au point S n'est pas affecté par la température. La diode 9 de compensation en température a une hauteur de barrière de $E'_D$ et on lui donne de grandes dimensions de sorte que la résistance série est négligeable :

$R'_S \simeq 0$

Le transistor 4 source de courant a une largeur de grille $Z'$ qui lui permet de débiter un courant $I'_D$ compte tenu de la présence de la diode 9 de compensation. Sa tension de polarisation grille-source est augmentée par la présence de la diode 9 de compensation :

$V_{GS} = - E'_D$

de sorte que le courant débité $I'_D$ est :

$I'_D = k \frac{Z'}{L} (V_{GS} - V_T)^2$

La largeur $Z'$ de la grille du transistor 4 peut d'ailleurs être facilement calculée pour retrouver en sortie les mêmes niveaux que pour une porte classique. A la température ambiante $T_A$, les courants doivent être les mêmes :

$$I'_D = I_D$$

$$k \frac{Z'}{L} (E'_D + V_T)^2 = k \frac{Z}{L} V_T^2$$

$$Z' = Z \left( \frac{V_T}{E'_D + V_T} \right)^2$$

A titre d'exemples pour $V_T \simeq -1\,V$, $E'_D \simeq 0,5\,V$, on obtient $Z' = 4Z$ ce qui est cohérent avec $R'_S \simeq 0$ pour la diode de compensation.

Dans le cas de l'invention, la tension de sortie $V_0$ est :

$V_0 = V_S - E_D - I'_D R_S$

$V_0 = V_S - E_D - k \frac{Z'}{L} (E'_D + V_T)^2 R_S$

$$\frac{dV_0}{dT} = - \frac{dE_D}{dT} - k \frac{Z'}{L} (E'_D + V_T)^2 \frac{dR_S}{dT}$$
$$- 2k \frac{Z'R_S}{L} \frac{(E'_D + V_T)^2}{(E'_D V_T)} \left( \frac{dE'_D}{dT} + \frac{dV_T}{dT} \right)$$

$$\frac{dV_0}{dT} = \alpha + \beta I_D + 2(\alpha + \beta) \frac{I_D R_S}{E'_D + V_T}$$

Il y compensation de la température si l'effet de la température est le même à la sortie d'une porte BFL selon l'invention et à l'entrée d'une porte suivante dans une série de portes identiques, soit si:

$$\frac{dV_0}{dT} = \frac{dV_T}{dT}$$

c'est-à-dire si :

$$\frac{dV_0}{dT} = - \gamma$$

Si :

$$\frac{dV_O}{dT} = O,$$

on se trouve dans le cas où, pour une porte BFL considérée isolément, le point de fonctionnement de la diode de décalage 5 est ramené au point 8 sur la figure 5 : le tension de décalage est maintenue constante, sans tenir compte de la dérive de $V_T$ du transistor d'entrée 1' d'une autre éventuelle porte BFL.

Si :

$$\frac{dV_O}{dT} = - \gamma \neq O,$$

on se trouve dans le cas où le point de fonctionnement de la diode de décalage 5 est forcée au point 10 de la figure 5, de façon à anticiper, pour une porte BFL selon l'invention, le décalage de la tension de seuil du transistor d'entrée 1' d'une autre porte BFL montée en série.

Pour remplir ces conditions, la résistance série optimale $R_S$ de la diode de décalage 5 est donnée par l'équation générale :

$$R_S(opt) = \frac{1}{2} \cdot \frac{1 + \dfrac{\gamma + \beta I_D}{\alpha}}{1 + \gamma/\alpha} \cdot \frac{|V_T| - E'_D}{I_D}$$

L'invention a été décrite en s'appuyant sur l'exemple d'une porte BFL qui ne comporte dans son second étage qu'une seule diode de décalage 5 et une seule diode de compensation 9. Bien entendu, l'invention reste valable pour une porte BFL qui comporte une pluralité de diodes de décalage et une pluralité de diodes de compensation.

## Revendications

1. Porte logique de type BFL, compensée en température, comportant, dans son étage d'entrée, un transistor d'entrée (1) dont la grille reçoit le signal logique d'entrée ($V_I$) et un transistor (2) alimenté par une première tension $V_{DD}$, et, dans son étage de sortie, un transistor intermédiaire (3), alimenté par la même tension $V_{DD}$ et dont la grille reçoit le signal issu du drain du transistor d'entrée (1), ce transistor intermédiaire (3) étant monté en série avec au moins une diode de décalage (5) elle-même en série avec une source de courant constituée par un transistor (4) alimenté par une deuxième tension $V_{SS}$, le signal logique de sortie ($V_o$) étant prélevé au point commun entre la diode de décalage (5) et le drain du transistor (4) source de courant, cette porte logique BFL étant caractérisée en ce que, en vue de compenser la variation avec la température de la chute de tension $V_D$ introduite par la diode de décalage (5), une diode de compensation (9) est introduite, dans le sens passant, entre la source et la grille du transistor (4) source de courant de l'étage de sortie, la deuxième tension d'alimentation $V_{SS}$étant appliquée au point commun entre la diode de compensation (9) et la grille du transistor (4).

2. Porte logique BFL compensée en température selon la revendication 1 caractérisée en ce que la polarisation $V_{GS}$ du transistor (4) source de courant varie avec la température en sens inverse de la chute de tension ($V_C$) dans la diode de compensation (9), ce qui fait varier le courant ($I_D$) débité par le transistor (4), et compense la chute de tension ($V_D$) dans la diode de décalage (5).

3. Porte logique BFL compensée en température selon la revendication 1 caractérisée en ce que la diode de compensation (9) est calculée suffisamment grande pour que sa résistance d'accès ($R'_S$), dans le sens passant, soit négligeable : $R'_S \simeq O$.

4. Porte logique BFL compensée en température selon la revendication 1 caractérisée en ce que la chute de tension ($V_C$) dans la diode de compensation (9) est calculée pour compenser la variation avec la température de la chute de tension ($V_D$) dans la diode de décalage (5).

5. Porte logique BFL compensée en température selon la revendication 1 caractérisée en ce que la chute de tension ($V_C$) dans la diode de compensation (9) est calculée pour compenser les variations avec la température de la chute de tension ($V_D$) dans la diode de décalage (5) de la tension de seuil ($V_T$) du transistor d'entrée (1') d'une seconde porte BFL montée en série sur la sortie ($V_o$) de ladite porte BFL.

6. Porte logique BFL compensée en température selon la revendication 1, caractérisée en ce que, pour avoir les mêmes niveaux de signal de sortie ($V_o$) qu'une porte BFL non compensée en température, et non dotée d'une diode de compensation (9), la largeur de grille ($Z'$) du transistor (4) source de courant est égale à :

$$Z' = Z \left( \frac{V_T}{E'_D + V_T} \right)^2$$

avec
$Z$ = largeur de grille du transistor (4) source de courant dans une porte BFL non compensée en température,
$V_T$ = tension de seuil du transistor (4) source de courant,
$E'_D$ = hauteur de barrière de la diode de compensation (9).

7. Porte logique BFL compensée en température selon la revendication 1, caractérisée en ce que la résistance d'accès ($R_S$) optimale pour la diode de décalage (5) est égale à :

$$R_S \ (opt) = \frac{1}{2} \cdot \frac{\dfrac{1 + \gamma + \beta \ I_D}{\alpha}}{1 + \gamma / \alpha} \cdot \frac{|V_T| - E'_D}{I_D}$$

dans laquelle :
• $I_D$ est le courant qui traverse la diode de décalage (5),
• $V_T$ est la tension de seuil du transistor source de courant (4),
• $E'_D$ est la hauteur de barrière de la diode de compensation(9),
• $\alpha$ est la variation avec la température de la hauteur de barrière ($E_D$) de la diode de décalage (5) : $dE_D/dT = -\alpha$
• $\beta$ est la variation avec la température de la résistance d'accès ($R_S$) de la diode de décalage (5) : $dR_S/dT = -\beta$
• $\gamma$ est la variation avec la température de la tension de seuil ($V_T$) du transistor source de courant(4) : $dVT/dT = -\gamma$

0256918

FIG_1

FIG_2

FIG_3

FIG_4

0256918

# FIG_5

compensée

$I_{DT2}$

$I_{DT2}$

$I_{DT1}$

$T_2 > T_1$

$\Delta V$

# FIG_6

$V_{DD}$

$V_I$

$I_D$

$V_D$

$V_O$

$V_{GS}$

$V_C$

$V_{SS}$

# FIG_7

$V_{DD}$

$I_D$

$R_S$

$E_D$ } DIODE

$V_O$

$Z/L$

$V_T$

$V_{SS}$

# FIG_8

$V_{DD}$

$I'_D$

$R_S$

$E_D$ } DIODE

$V_O$

$Z'/L$

$V_T$

$R'_S \simeq 0$

$E'_D$

$V_{SS}$

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl 4) |
|---|---|---|---|
| Y | IEEE JOURNAL OF SOLID-STATE CIRCUITS, vol. SC-19, no. 5, octobre 1984, pages 728-738, IEEE, New York, US; R.N. DEMING et al.: "A gallium arsenide configurable cell array using buffered FET logic" * Figure 1c; page 729, colonne de droite, lignes 6-31 * | 1,2,4, 5 | H 03 K 19/094 H 03 K 19/00 |
| | --- | | |
| Y | INTERNATIONAL JOURNAL OF ELECTRONICS, vol. 29, no. 5, novembre 1970, pages 461-463, Londres, GB; R. LINGGARD et al.: "High impedance unit gain amplifiers using field effect junction transistors" * Figures 1a,1b; page 461, lignes 10-17; page 462, lignes 1-3 * | 1,2,4, 5 | |
| | --- | | DOMAINES TECHNIQUES RECHERCHES (Int. Cl.4) |
| A | DE-A-3 336 949 (TEKTRONIX) * Figure 2; page 4, lignes 6-28 * | 1,2,4, 5 | H 03 K H 03 F |
| | ----- | | |

Le présent rapport de recherche a été établi pour toutes les revendications

| Lieu de la recherche | Date d'achèvement de la recherche | Examinateur |
|---|---|---|
| LA HAYE | 04-11-1987 | FEUER F.S. |